(19) Europäisches Patentamt / European Patent Office / Office européen des brevets

(11) **EP 3 772 634 B1**

(12) **FASCICULE DE BREVET EUROPEEN**

(45) Date de publication et mention
de la délivrance du brevet:
**30.08.2023   Bulletin 2023/35**

(21) Numéro de dépôt: **20188483.0**

(22) Date de dépôt: **29.07.2020**

(51) Classification Internationale des Brevets (IPC):
**G01F 15/063** *(2022.01)*      **F17D 1/04** *(2006.01)*
**G01M 3/28** *(2006.01)*      **G05B 23/02** *(2006.01)*
**G01D 4/00** *(2006.01)*

(52) Classification Coopérative des Brevets (CPC):
**G01F 15/007; G01D 4/002; G01F 15/063;
G01M 3/28; G05B 23/0297;** F17D 1/04;
Y02B 90/20; Y04S 20/30

(54) **PROCEDE DE SURVEILLANCE D'UN ENSEMBLE DE COMPTEURS**

VERFAHREN ZUR ÜBERWACHUNG EINER GESAMTHEIT VON ZÄHLERN

METHOD FOR MONITORING A SET OF METERS

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité:  **09.08.2019   FR 1909128**

(43) Date de publication de la demande:
**10.02.2021   Bulletin 2021/06**

(73) Titulaire: **Sagemcom Energy & Telecom SAS
92500 Rueil-Malmaison (FR)**

(72) Inventeur: **TEBOULLE, Henri
92500 Rueil-Malmaison (FR)**

(74) Mandataire: **Lavaud, Thomas
Cabinet Boettcher
5, rue de Vienne
75008 Paris (FR)**

(56) Documents cités:
**EP-A1- 2 472 467       WO-A1-2015/089594
WO-A1-2017/005269       WO-A1-2018/162250
WO-A1-2018/183140       JP-B2- 5 130 220
JP-B2- 5 130 220       US-A1- 2012 232 915
US-A1- 2015 323 344       US-B1- 9 424 742**

EP 3 772 634 B1

## Description

L'invention concerne le domaine des compteurs intelligents : compteurs d'eau, de gaz, d'électricité, etc.

## ARRIERE PLAN DE L'INVENTION

On assiste aujourd'hui à un très large déploiement des compteurs dits « intelligents ». Les compteurs intelligents dont il est ici question sont utilisés pour mesurer un flux quelconque fourni à une installation par un réseau de distribution : eau, gaz, électricité, etc.

Ces compteurs intelligents ne se contentent pas d'effectuer des mesures, mais sont aussi capables de réaliser un certain nombre de fonctions complémentaires : gestion des tarifs par réception d'ordres, relève et programmation à distance, téléinformation client, etc.

Les compteurs intelligents sont organisés en de véritables réseaux de compteurs au sein desquels circulent à la fois des données montantes transmises par les compteurs au fournisseur ou au gestionnaire du réseau, et des données descendantes reçues par les compteurs. Chacun de ces réseaux comporte classiquement un grand nombre de compteurs reliés à un même Système d'Information (SI), éventuellement via des équipements intermédiaires tels que des concentrateurs de données ou des *gateways* (que l'on peut traduire en français par « passerelles »).

Dans un tel réseau, il est fondamental d'être en mesure de détecter efficacement et de manière fiable les anomalies pouvant se produire, et notamment les défauts survenant dans les installations (par exemple des fuites d'eau ou de gaz) ou les tentatives de fraude subies par les compteurs. En effet, l'un des intérêts du développement des réseaux de compteurs intelligents est de réduire au maximum les interventions d'opérateurs du fournisseur ou du gestionnaire du réseau pour vérifier le bon fonctionnement des compteurs. Le document de brevet EP 2 472 467 A1 décrit un procédé de surveillance d'un ensemble de compteurs connectés à un même dispositif de traitement distant. Le procédé de surveillance comprend dans chaque compteur l'acquisition de mesures primaires d'une grandeur représentative de la survenue d'une anomalie, et la transmission régulière au dispositif de traitement distant de mesures pertinentes. Le procédé de surveillance comprend aussi dans le dispositif de traitement distant des détecteurs d'anomalie pour tenter de détecter des anomalies dans le fonctionnement des compteurs.

On cherche donc à rendre plus robuste la détection des anomalies, sans pour autant complexifier les compteurs, et en limitant le volume des échanges de données sur le réseau afin d'impacter le moins possible la consommation électrique des compteurs. Ce dernier point est particulièrement critique pour les compteurs d'eau ou de gaz qui sont alimentés par une ou des piles et dont la durée de vie, sans changer la ou les piles, doit être très importante, typiquement égale à 20 ans.

## OBJET DE L'INVENTION

L'invention a pour objet d'améliorer la détection des anomalies survenant sur les compteurs ou dans les installations auxquelles sont reliés lesdits compteurs, tout en limitant les échanges de données nécessaires pour cette détection et sans complexifier les compteurs.

## RESUME DE L'INVENTION

En vue de la réalisation de ce but, on propose un procédé de surveillance d'un ensemble de compteurs, chaque compteur étant agencé pour mesurer un flux fourni à une installation par un réseau de distribution, tous les compteurs étant connectés à un même dispositif de traitement distant, le procédé de surveillance comprenant les premières étapes, mises en œuvre dans chaque compteur, de :

- acquérir des mesures primaires d'une grandeur représentative de la survenue d'une anomalie associée audit compteur ;
- sélectionner, parmi les mesures primaires, des mesures pertinentes qui vérifient un critère de pertinence ;
- transmettre régulièrement au dispositif de traitement distant les mesures pertinentes ;

et les deuxièmes étapes, mises en œuvre dans le dispositif de traitement distant, de :

- pour chaque compteur, réaliser une comparaison des mesures pertinentes avec un seuil de détection commun à tous les compteurs de l'ensemble de compteurs, pour tenter de détecter une anomalie associée audit compteur ;
- ajuster dynamiquement le seuil de détection en fonction d'un taux détecté d'anomalies.

Une anomalie associée à un compteur est par exemple un défaut dans l'installation associée audit compteur (une fuite par exemple), ou bien une tentative de fraude sur ledit compteur.

Ainsi, dans le procédé de surveillance selon l'invention, c'est le dispositif de traitement distant qui ajuste dynamiquement le seuil de détection qui permet de détecter une anomalie. Cette solution améliore la précision et la robustesse de la détection, car le dispositif de traitement distant est relié à tous les compteurs et peut donc évaluer statistiquement les résultats de détection obtenus par tous les compteurs, ce qu'un compteur seul est incapable de faire.

L'invention est basée sur du *Edge Computing* (que l'on peut traduire en français par « informatique en périphérie ») au niveau des compteurs. Chaque compteur produit des mesures primaires et réalise un prétraitement sur les mesures primaires, qui consiste à sélectionner les mesures pertinentes et à les mettre en forme pour les transmettre régulièrement au dispositif de traitement distant qui centralise et analyse ces mesures pertinentes.

Comme le seuil de détection est élaboré au sein du dispositif de traitement distant, c'est-à-dire à l'extérieur des compteurs, on évite d'avoir à remonter les messages d'anomalies qui sont, selon l'invention, directement détectées par le dispositif de traitement distant. On minimise ainsi le volume des échanges sur le réseau et on impacte très peu la consommation électrique des compteurs.

On note aussi que l'acquisition des mesures primaires et le prétraitement qui vient d'être évoqué ne nécessitent pas de reprogrammer les compteurs régulièrement, ce qui limite à nouveau le volume des échanges sur le réseau. Par ailleurs, ces opérations sont très simples et ne complexifient pas le compteur au niveau *hardware* (que l'on peut traduire en français par « matériel ») ou au niveau logiciel.

Optionnellement, une anomalie associée à un compteur est un défaut dans l'installation associée audit compteur ou une tentative de fraude sur ledit compteur.

Optionnellement, les compteurs sont des compteurs d'un fluide, et dans lequel le défaut dans l'installation possiblement détecté est une fuite du fluide dans l'installation.

Optionnellement, les compteurs comprennent chacun un dispositif de mesure ultrasonique d'une vitesse du fluide, dans lequel la grandeur représentative de la survenue d'une fuite est une vitesse moyennée Vmoy du fluide sur une première durée prédéterminée, et dans lequel le critère de pertinence est la condition :

$|Vmoy| \leq Seuil\_V1$, où $|Vmoy|$ est une valeur absolue de la vitesse moyennée Vmoy et où Seuil\_V1 est un seuil de vitesse prédéterminé.

Optionnellement, pour chaque compteur, le dispositif de traitement distant détecte une fuite dans l'installation associée audit compteur lorsque, sur une deuxième durée prédéterminée, on a : $N1 \geq K1$, où K1 est un seuil de fuite prédéterminé, et où N1 est le nombre de vitesses moyennées telles que :

$$Vmoy > Seuil\_V2,$$

où Seuil\_V2 est le seuil de détection.

Optionnellement, lorsqu'un taux détecté d'installations subissant une fuite est supérieur à un premier taux de fuite prédéterminé, le dispositif de traitement distant (6) augmente le seuil de détection pour que le taux détecté d'installations subissant une fuite devienne inférieur ou égal au premier taux de fuite prédéterminé. Optionnellement, la grandeur représentative de la survenue d'une fuite est une différence d'index $\Delta C$ entre une valeur maximale et une valeur minimale d'un index métrologique du compteur sur une troisième durée prédéterminée, et dans lequel le critère prédéterminé est la condition : $\Delta C \leq Seuil\_C1$, où Seuil\_C1 est un seuil d'index prédéterminé.

Optionnellement, pour chaque compteur, le dispositif de traitement distant détecte une fuite dans l'installation associée audit compteur lorsque, sur une quatrième durée prédéterminée, on a :

$(\Delta Cmax - \Delta Cmin) \geq Seuil\_C2$, où $\Delta Cmax$ est la valeur maximale de la différence d'index $\Delta C$ et où $\Delta Cmin$ est la valeur minimale de la différence d'index $\Delta C$, et où Seuil\_C2 est le seuil de détection.

Optionnellement, lorsqu'un taux détecté d'installations subissant une fuite est supérieur à un deuxième taux de fuite prédéterminé, le dispositif de traitement distant (6) augmente le seuil de détection pour que le taux détecté d'installations subissant une fuite devienne inférieur ou égal au deuxième taux de fuite prédéterminé.

Optionnellement, les compteurs sont des compteurs d'un fluide qui comprennent chacun un dispositif de mesure ultrasonique d'une vitesse du fluide, et dans lequel la tentative de fraude possiblement détectée est une tentative de fraude ultrasonique.

Optionnellement, la grandeur représentative de la survenue de la tentative de fraude est un niveau de signal ultrasonique parasite mesuré lorsque le dispositif de mesure ultrasonique n'émet pas de signal ultrasonique de mesure, et dans lequel le critère de pertinence est tel que les mesures pertinentes comprennent, sur une cinquième durée prédéterminée, un premier nombre prédéterminé des niveaux de signal ultrasonique parasite les plus élevés en valeur absolue.

Optionnellement, pour chaque compteur, le dispositif de traitement distant (6) détecte une tentative de fraude lorsque, sur une sixième durée prédéterminée, on a :

$N2 \geq K2$, où K2 est un seuil de fraude prédéterminé, et où N2 est le nombre de niveaux de signal ultrasonique parasite tels que :

$|Nc| > Seuil\_Nc$, où Seuil\_Nc est le seuil de détection.

Optionnellement, lorsqu'un taux détecté de compteurs subissant une tentative de fraude est supérieur à un premier taux de fraude prédéterminé, le dispositif de traitement distant augmente le seuil de détection pour que le taux détecté de compteurs subissant une tentative de fraude devienne inférieur ou égal au premier taux de fraude prédéterminé.

Optionnellement, les compteurs comprennent chacun un magnétomètre destiné à détecter une tentative de fraude magnétique.

Optionnellement, le magnétomètre est un magnétomètre 3D, dans lequel la grandeur représentative de la survenue de la tentative de fraude est une grandeur magnétique égale à : $(|Bx|+|By|+|Bz|)$, Bx, By et Bz étant des valeurs en Tesla d'un champ magnétique mesuré selon trois axes X, Y et Z, et dans lequel le critère de pertinence est tel que les mesures pertinentes comprennent, sur une septième durée prédéterminée, un deuxième nombre prédéterminé des valeurs Bx, By et Bz des grandeurs magnétiques les plus élevées.

Optionnellement, pour chaque compteur, le dispositif de traitement distant détecte une tentative de fraude lorsque, sur une huitième durée prédéterminée, on a au moins une valeur du module B telle que :

$$B > Seuil\_B,$$

où Seuil B est le seuil de détection et où :

$$B = \sqrt{B_x^2 + B_y^2 + +B_z^2}.$$

Optionnellement, lorsqu'un taux détecté de compteurs subissant une tentative de fraude est supérieur à un deuxième taux de fraude prédéterminé, le dispositif de traitement distant augmente le seuil de détection pour que le taux détecté de compteurs subissant une tentative de fraude devienne inférieur ou égal au deuxième taux de fraude prédéterminé.

On propose un système de mesure comprenant un ensemble de compteurs et un dispositif de traitement distant, chaque compteur étant agencé pour mesurer un flux fourni à une installation par un réseau de distribution, tous les compteurs étant connectés au dispositif de traitement distant, le procédé de surveillance tel que précité étant mis en oeuvre dans ledit système de mesure.

On propose un dispositif de traitement distant, agencé pour être connecté à un ensemble de compteurs, chaque compteur étant agencé pour mesurer un flux fourni à une installation par un réseau de distribution, le dispositif de traitement comprenant un module d'application dans lequel les deuxièmes étapes du procédé de surveillance tel que précité sont mises en oeuvre.

L'invention sera mieux comprise à la lumière de la description qui suit d'un mode de mise en oeuvre particulier non limitatif de l'invention.

BREVE DESCRIPTION DES DESSINS

Il sera fait référence au dessin annexé suivant :

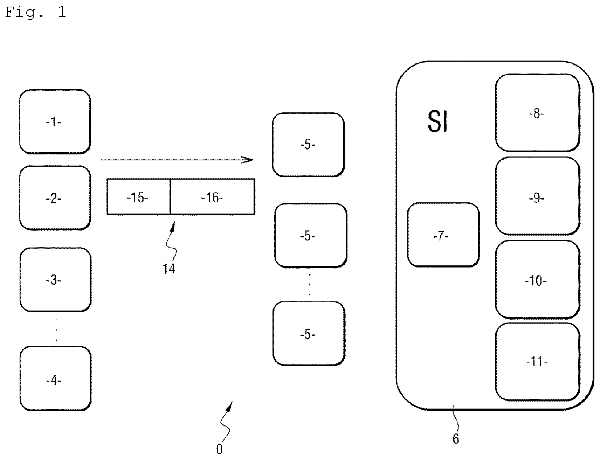

[Fig. 1] la figure 1 représente un système de mesure comprenant quatre ensembles de compteurs, des *gateways* et un Système d'Information.

DESCRIPTION DETAILLEE DE L'INVENTION

En référence à la figure 1, l'invention est ici mise en oeuvre dans un système 0 qui comporte un premier ensemble de compteurs 1, un deuxième ensemble de compteurs 2, un troisième ensemble de compteurs 3 et un quatrième ensemble de compteurs 4. Le système 0 comporte de plus une pluralité de *gateways* 5. Le système 0 comporte aussi un dispositif de traitement distant qui est en l'occurrence un Système d'Information (SI) 6.

Le SI 6 comporte un module LNS 7 (pour *LoRa Network Server,* que l'on peut traduire en français par « serveur de réseau LoRa ») ainsi qu'un premier module d'application 8, un deuxième module d'application 9, un troisième module d'application 10 et un quatrième module d'application 11.

Tous les compteurs sont connectés au SI 6 via les *gateways* 5. Les compteurs communiquent avec le SI 6 via un réseau LoRa (pour *Long Range,* que l'on peut traduire en français par « longue portée »). Bien sûr, un autre type de réseau radiofréquence pourrait être utilisé, par exemple un réseau qui utilise une bande de fréquence autour de 169MHz ou bien toute autre technologie radiofréquence à basse consommation et longue portée. Les compteurs pourraient aussi être reliés à un dispositif de traitement distant par des moyens de communication différents : moyens filaires, courants porteurs en ligne, etc.

Dans le cas du LoRa, on utilise ici une bande ISM (pour Industrie, Science et Médical) pour émettre des données montantes depuis les compteurs vers le SI 6, en l'occurrence la bande 863 à 870MHz en Europe.

On note que tous les compteurs qui émettent dans ladite bande ISM doivent alors respecter un *duty cycle* (que l'on peut traduire en français par « rapport cyclique ») de 0.1% (c'est-à-dire qu'ils n'émettent pas plus de 0.1% du temps, soit pas plus de 3,6s par heure).

Chaque compteur comprend un composant de traitement adapté à exécuter des instructions d'un programme pour mettre en oeuvre le procédé de surveillance selon l'invention. Le composant de traitement est ici un microcontrôleur mais pourrait être un composant différent, par exemple un microprocesseur, un FPGA, un ASIC, etc.

On s'intéresse tout d'abord aux compteurs du premier ensemble de compteurs 1, qui mettent en oeuvre un premier mode de surveillance et qui communiquent, via les *gateways* 5 et le module LNS 7, avec le premier module d'application 8 du SI 6.

Les compteurs du premier ensemble 1 sont des compteurs d'eau et sont chacun agencés pour mesurer un débit d'eau fourni à une installation par un réseau de distribution.

Chacun de ces compteurs comprend un dispositif de mesure ultrasonique d'une vitesse de l'eau.

Le dispositif de mesure ultrasonique comporte un conduit, raccordé à un tuyau relié au réseau de distribution, dans lequel circule l'eau. Le dispositif de mesure comporte aussi un premier transducteur et un deuxième transducteur qui sont appairés en fréquence et en niveau d'émission. Le premier transducteur et le deuxième transducteur sont par exemple des transducteurs piézoélectriques.

Le premier transducteur émet dans le conduit un premier signal ultrasonique de mesure émis qui parcourt un trajet de longueur définie. Le deuxième transducteur reçoit un premier signal ultrasonique de mesure reçu résultant de la propagation dans le fluide du premier signal ultrasonique de mesure émis. On mesure alors le temps de trajet mis par le premier signal ultrasonique de mesure émis pour parcourir le trajet de longueur définie d'amont en aval.

De même, le deuxième transducteur émet dans le conduit un deuxième signal ultrasonique de mesure émis. Le premier transducteur reçoit un deuxième signal ultrasonique de mesure reçu résultant de la propagation dans le fluide du deuxième signal ultrasonique de mesure émis. On mesure alors le temps de trajet mis par le deuxième signal ultrasonique de mesure émis pour parcourir le trajet de longueur définie d'aval en amont.

On estime la vitesse de l'eau V à partir notamment de la longueur définie du trajet et de la différence entre les temps de trajet. La vitesse de l'eau V est une vitesse moyenne de l'eau dans le conduit.

Le compteur transmet régulièrement au SI 6 des trames contenant des données classiquement transmises par un tel compteur d'eau. Ces données incluent des estimations du débit d'eau fourni à l'installation, ainsi que diverses autres données.

Pour mettre en oeuvre le procédé de surveillance selon l'invention, le compteur va, en plus de ces trames émises de manière classique, transmettre au SI 6 des trames de surveillance.

Le compteur envoie ici 4 trames de surveillance par jour, soit une toutes les 6 heures, sachant qu'en SF12 (293 bit/s - SF pour *Spreading Factor,* que l'on peut traduire en français par « facteur d'étalement »), la durée d'émission d'une trame LoRa comprenant une *Payload* (que l'on peut traduire en français par « charge utile ») typique *FRMPayload* de 51 octets est de l'ordre de 2,5s. Ces nouvelles trames de surveillance représentent donc une durée totale de 2,5s toutes les 6 heures, ce qui est relativement faible par rapport au *duty cycle* évoqué plus tôt.

On décrit maintenant, pour chaque compteur du premier ensemble de compteurs 1, le contenu des trames de surveillance.

Le composant de traitement du compteur produit des mesures primaires d'une grandeur représentative de la survenue d'une anomalie associée au compteur. L'anomalie possiblement détectée est ici un défaut survenant dans l'installation, une fuite d'eau en l'occurrence.

La grandeur représentative de la survenue d'une fuite est une vitesse moyennée Vmoy de l'eau sur une première durée prédéterminée, qui est égale ici à 15mn.

Le composant de traitement intègre la vitesse de l'eau V (qui est elle-même, comme on vient de le voir, une vitesse moyenne de l'eau dans le conduit) mesurée par le dispositif de mesure 8 fois par secondes sur 15mn, pour obtenir la vitesse moyennée Vmoy, qui est une moyenne arithmétique.

La vitesse moyennée Vmoy est alors mémorisée sur 2 octets.

Les vitesses moyennées Vmoy acquises toutes les 15mn forment donc les mesures primaires.

Puis, le composant de traitement sélectionne, parmi les mesures primaires, des mesures pertinentes qui vérifient un critère de pertinence. Le composant de traitement du compteur sélectionne uniquement les vitesses moyennées en situation de *Zéro-flow* (que l'on peut traduire en français par « flux nul »), c'est-à-dire dans une situation où les équipements de l'installation ne consomment pas d'eau.

Le critère de pertinence est donc ici la condition suivante :
|Vmoy| ≤ Seuil_V1, où |Vmoy| est une valeur absolue de la vitesse moyennée Vmoy et où Seuil _V1 est un seuil de vitesse prédéterminé.

Pour une période de 6 heures (soit 24 x 15 minutes), il suffit de 48 octets (sur 51) pour stocker les vitesses moyennées Vmoy sur chaque période de 15 minutes.

Le composant de traitement transmet régulièrement au SI 6 ces mesures pertinentes, en l'occurrence toutes les 6 heures.

On note que la longueur définie L du trajet entre le premier transducteur et le deuxième transducteur du dispositif de mesure ultrasonique, propre à chaque compteur et déterminée lors de la calibration en usine, est fournie systématiquement au SI 6 sur un des trois octets restant.

Le premier module d'application 8 du SI 6 reçoit les trames de surveillance ou, plus précisément, des paquets de surveillance 14. Chaque paquet de surveillance 14 comprend une adresse 15 du compteur qui envoie ledit paquet de surveillance, ainsi qu'une trame de surveillance LoRa 16 qui comprend un *header* (que l'on peut traduire en français par « entête ») qui désigne le premier mode de surveillance dans lequel fonctionne le compteur (qui appartient au premier ensemble de compteurs 1), ce qui permet de diriger le paquet de surveillance 14 vers le premier module d'application 8.

Pour chaque compteur, le premier module d'application 8 réalise une comparaison des mesures pertinentes avec un premier seuil de détection commun à tous les compteurs du premier ensemble de compteurs 1, pour tenter de détecter une fuite d'eau dans l'installation associée au compteur.

Pour chaque compteur du premier ensemble 1, le SI 6 reçoit donc toutes les 6 heures 24 vitesses moyennées Vmoy relatives à des périodes de *Zéro-flow.*

Le premier module d'application 8 détecte une fuite dans l'installation lorsque, sur une deuxième durée prédéterminée, qui est ici égale à 6 heures, on a :
N1 ≥ K1, où K1 est un seuil de fuite prédéterminé, et où N1 est le nombre de vitesse moyennées Vmoy telles que :

```
Vmoy > Seuil_V2,
```

où Seuil_V2 est le premier seuil de détection commun à tous les compteurs du premier ensemble de compteurs 1.

Ici, K1 est égal à 16.

Ainsi, si on constate un biais positif concernant le signe de ces 24 valeurs de vitesse moyennée Vmoy, et si au moins 16 de ces 24 valeurs vérifient :

$$Vmoy > Seuil\_V2,$$

on considère qu'il y a une fuite dans l'installation.

Le premier seuil de détection Seuil_V2 est ici égal à 0.5L/h.

Le premier module d'application 8 va aussi ajuster dynamiquement le premier seuil de détection Seuil_V2 en fonction d'un taux détecté d'anomalies, c'est-à-dire d'un taux détecté (par le SI 6) d'installations subissant une panne.

Le SI 6 reçoit en effet périodiquement les trames de surveillance émises par tous les compteurs du premier ensemble de compteurs 1, auxquels il est connecté via le réseau LoRa.

Lorsque le taux détecté d'installations subissant une fuite est supérieur à un premier taux de fuite prédéterminé, le premier module d'application 8 augmente le premier seuil de détection Seuil_V2 pour que le taux détecté d'installations subissant une fuite devienne inférieur ou égal au premier taux de fuite prédéterminé.

On considère en effet qu'on ne peut pas avoir simultanément plus de F1% de fuites dans toutes les installations associées au premier ensemble de compteurs 1.

F1 est le premier taux de fuite prédéterminé et est ici égal à 8%.

Ainsi, si le premier module d'application 8 détecte plus de 8% d'installations en fuite, cela signifie que le premier seuil de détection Seuil_V2 est mal réglé et est trop bas. Le premier module d'application 8 ajuste dynamiquement le premier seuil de détection Seuil_V2 pour diminuer le taux détecté d'installations subissant une fuite de manière à ce qu'il devienne inférieur ou égal à 8%.

On s'intéresse maintenant aux compteurs du deuxième ensemble de compteurs 2, qui mettent en oeuvre un deuxième mode de surveillance et qui communiquent, via les *gateways* 5 et le module LNS 7, avec le deuxième module d'application 9 du SI 6.

Les compteurs du deuxième ensemble 2 sont des compteurs de gaz et sont chacun agencés pour mesurer une quantité de gaz distribuée à une installation par un réseau de distribution.

Chacun de ces compteurs comprend un dispositif de mesure qui mesure le volume de gaz consommé et qui incrémente un index métrologique représentatif du volume de gaz consommé.

Le compteur transmet régulièrement au SI 6 des trames contenant des données classiquement transmises par un tel compteur de gaz. Ces données incluent des données de mesure représentatives de la quantité de gaz distribuée à l'installation, par exemple l'index totalisateur métrologique, ainsi que diverses autres données.

Pour mettre en oeuvre le procédé de surveillance selon l'invention, le compteur va, en plus de ces trames émises de manière classique, transmettre au SI 6 des trames de surveillance.

A nouveau, le compteur envoie ici 4 trames de surveillance par jour, soit une toutes les 6 heures. Ces nouvelles trames de surveillance représentent donc une durée totale de 2,5s toutes les 6 heures.

On décrit maintenant, pour chaque compteur du deuxième ensemble de compteurs 2, le contenu des trames de surveillance.

Le composant de traitement du compteur produit des mesures primaires d'une grandeur représentative de la survenue d'une anomalie associée au compteur. L'anomalie possiblement détectée est ici un défaut survenant dans l'installation, une fuite de gaz en l'occurrence.

La grandeur représentative de la survenue d'une fuite est une différence d'index $\Delta C$ entre les deux octets de poids faible d'une valeur maximale Cmax et les deux octets de poids faible d'une valeur minimale Cmin de l'index métrologique C du compteur sur une troisième durée prédéterminée. L'index métrologique C est mesuré 1 fois par seconde. La troisième durée prédéterminée est ici égale à 15mn.

La différence d'index $\Delta C$ est alors mémorisée sur 2 octets.

Les différences d'index $\Delta C$ acquises toutes les 15mn forment donc les mesures primaires.

Puis, le composant de traitement sélectionne, parmi les mesures primaires, des mesures pertinentes qui vérifient un critère de pertinence.

Le critère de pertinence est la condition :

$$\Delta C = (Cmax - Cmin) \leq Seuil\_C1,$$

où Seuil_C1 est un seuil d'index prédéterminé.

Typiquement, Seuil_C1 = 2.

On sélectionne donc les différences d'index $\Delta C$ en situation de *Zéro-flow,* c'est-à-dire dans une situation où les équipements de l'installation ne consomment pas de gaz.

Pour une période de 6 heures (soit 24 x 15 minutes), il suffit de 48 octets (sur 51) pour stocker les valeurs de différence d'index $\Delta C$.

Le composant de traitement transmet régulièrement au SI 6 ces mesures pertinentes, en l'occurrence toutes les 6 heures.

Le deuxième module d'application 9 du SI 6 reçoit les trames de surveillance ou, plus précisément, des paquets de surveillance 14. Chaque paquet de surveillance 14 comprend une adresse 15 du compteur qui l'envoie, ainsi qu'une trame de surveillance LoRa 16 qui comprend un *header* qui désigne le deuxième mode de surveillance dans lequel fonctionne le compteur (qui appartient au deuxième ensemble de compteurs 2), ce qui permet de diriger le paquet de surveillance 14 vers le deuxième module d'application 9.

Pour chaque compteur, le deuxième module d'application 9 réalise une comparaison des mesures pertinentes avec un deuxième seuil de détection commun à tous les compteurs du deuxième ensemble de compteurs 2, pour tenter de détecter une fuite dans l'installation.

Pour chaque compteur du deuxième ensemble 2, le SI 6 reçoit donc toutes les 6 heures 24 valeurs de différence d'index $\Delta C$ relatives à des périodes de *Zéro-flow.*

Le deuxième module d'application 9 détecte une fuite de gaz dans l'installation associée au compteur lorsque, sur une quatrième durée prédéterminée, qui est égale à 6 heures, et donc sur les 24 valeurs de différence d'index $\Delta C$, on a :

$$(\Delta Cmax - \Delta Cmin) \geq Seuil\_C2,$$

où $\Delta Cmax$ est la valeur maximale de la différence d'index $\Delta C$ et où $\Delta Cmin$ est la valeur minimale de la différence d'index $\Delta C$ sur la quatrième durée prédéterminée, et où Seuil_C2 est le deuxième seuil de détection.

Typiquement, Seuil_C2 = 3.

Le deuxième module d'application 9 va aussi ajuster dynamiquement le deuxième seuil de détection Seuil_C2 en fonction d'un taux détecté d'anomalies, c'est-à-dire d'un taux détecté d'installations subissant une fuite.

Le SI 6 reçoit en effet périodiquement les trames de surveillance émises par tous les compteurs du deuxième ensemble de compteurs 2, auxquels il est connecté via le réseau LoRa.

Lorsque le taux détecté d'installations subissant une fuite est supérieur à un deuxième taux de fuite prédéterminé, le deuxième module d'application 9 augmente le deuxième seuil de détection Seuil_C2 pour que le taux détecté d'installations subissant une fuite devienne inférieur ou égal au deuxième taux de fuite prédéterminé.

On considère en effet qu'on ne peut pas avoir simultanément plus de F2% de fuites dans toutes les installations associées au deuxième ensemble de compteurs 2.

F2 est le deuxième taux de fuite prédéterminé et est ici égal à 8%.

Ainsi, si le deuxième module d'application 9 détecte plus de 8% d'installations en fuite, cela signifie que le deuxième seuil de détection Seuil_C2 est mal réglé et est trop bas. Le deuxième module d'application 9 ajuste dynamiquement le deuxième seuil de détection Seuil_C2 pour diminuer le taux détecté d'installations subissant une fuite de manière à ce qu'il devienne inférieur ou égal à 8%.

On s'intéresse maintenant aux compteurs du troisième ensemble de compteurs 3, qui mettent en oeuvre un troisième mode de surveillance et qui communiquent, via les *gateways* 5 et le module LNS 7, avec le troisième module d'application 10 du SI 6.

Les compteurs du troisième ensemble 3 sont des compteurs d'eau et sont chacun agencés pour mesurer un débit d'eau fourni à une installation par un réseau de distribution.

Chacun de ces compteurs comprend un dispositif de mesure ultrasonique d'une vitesse de l'eau, qui comporte un premier transducteur et un deuxième transducteur.

Le compteur transmet régulièrement au SI 6 des trames contenant des données classiquement transmises par un tel compteur d'eau. Ces données incluent des estimations du débit d'eau fourni à l'installation, ainsi que diverses autres données.

Pour mettre en oeuvre le procédé de surveillance selon l'invention, le compteur va, en plus de ces trames habituelles, transmettre au SI 6 des trames de surveillance.

A nouveau, le compteur envoie ici 4 trames de surveillance par jour, soit une toutes les 6 heures. Ces nouvelles trames de surveillance représentent donc une durée totale de 2,5s toutes les 6 heures.

On décrit maintenant, pour chaque compteur du troisième ensemble de compteurs 3, le contenu des trames de surveillance.

Le composant de traitement du compteur produit des mesures primaires d'une grandeur représentative de la survenue d'une anomalie associée au compteur. L'anomalie possiblement détectée est une tentative de fraude ultrasonique sur le compteur.

La grandeur représentative de la survenue de la tentative de fraude est un niveau de signal ultrasonique parasite mesuré lorsque le dispositif de mesure ultrasonique n'émet pas de signal ultrasonique de mesure via le premier transducteur et le deuxième transducteur.

Le compteur réalise 1 fois par minute dans ses silences (c'est-à-dire dans les moments où il n'émet pas de signal ultrasonique de mesure) une mesure à la réception de chacun de ses transducteurs du niveau de signal ultrasonique parasite Nc reçu. Le niveau de signal ultrasonique parasite Nc est un niveau crête.

Le niveau de signal ultrasonique parasite Nc est mémorisé sur 1 octet.

Les valeurs de niveau de signal ultrasonique parasite Nc forment donc les mesures primaires.

Puis, le composant de traitement sélectionne, parmi les mesures primaires, des mesures pertinentes qui vérifient un critère de pertinence.

Le critère de pertinence est tel que les mesures pertinentes comprennent, sur une cinquième durée prédéterminée, un premier nombre prédéterminé Np1 des niveaux de signal ultrasonique parasite Nc les plus élevés en valeur absolue.

Le premier nombre prédéterminé Np1 est égal à 48 et la cinquième durée prédéterminée est égale à 6 heures.

On sélectionne donc les 48 niveaux de signal ultrasonique parasite Nc les plus élevés en valeur absolue sur une durée de 6 heures.

Le composant de traitement transmet régulièrement au SI 6 ces mesures pertinentes, en l'occurrence toutes les 6 heures.

Le troisième module d'application 10 du SI 6 reçoit les trames de surveillance ou, plus précisément, des paquets de surveillance 14. Chaque paquet de surveillance 14 comprend une adresse 15 du compteur qui l'envoie, ainsi qu'une trame de surveillance LoRa 16 qui comprend un *header* qui désigne le troisième mode de surveillance dans lequel fonctionne le compteur (qui appartient au troisième ensemble de compteurs 3), ce qui permet de diriger le paquet de surveillance 14 vers le troisième module d'application 10.

Pour chaque compteur, le troisième module d'application 10 réalise une comparaison des mesures pertinentes avec un troisième seuil de détection commun à tous les compteurs du troisième ensemble de compteurs 3, pour tenter de détecter une tentative de fraude sur le compteur.

Pour chaque compteur du troisième ensemble 3, le SI 6 reçoit donc toutes les 6 heures les 48 niveaux de signal ultrasonique parasite Nc les plus élevés en valeur absolue, les mesures des niveaux étant réalisées dans les silences dudit compteur.

Le troisième module d'application 10 détecte une tentative de fraude sur le compteur lorsque, sur une sixième durée prédéterminée, on a : $N2 \geq K2$, où $K2$ est un seuil de fraude prédéterminé, et où $N2$ est le nombre de niveaux de signal ultrasonique parasite Nc tels que : $|Nc| > Seuil\_Nc$, où $Seuil\_Nc$ est le troisième seuil de détection.

Ici, $K2$ est égal à 16.

La sixième durée prédéterminée est égale à 6 heures et correspond donc aux 48 niveaux de signal ultrasonique parasite Nc reçus.

On fixe donc le troisième seuil de détection tel que, si 16 valeurs de niveau de signal ultrasonique parasite Nc sont en valeur absolue strictement supérieures au troisième seuil de détection Seuil_Nc, on considère qu'il y a fraude.

Ici, Seuil_Nc est égal à 0,5V. Seuil_Nc dépend de la conception du dispositif de mesure ultrasonique.

Le troisième module d'application 10 va aussi ajuster dynamiquement le troisième seuil de détection Seuil_Nc en fonction d'un taux détecté d'anomalies, c'est-à-dire d'un taux détecté de compteurs subissant une tentative de fraude.

Le SI 6 reçoit en effet périodiquement les trames de surveillance émises par tous les compteurs du troisième ensemble de compteurs 3, auxquels il est connecté via le réseau LoRa.

Lorsque le taux détecté de compteurs subissant une tentative de fraude est supérieur à un premier taux de fraude prédéterminé, le troisième module d'application 10 augmente le troisième seuil de détection Seuil_Nc pour que le taux détecté de compteurs subissant une tentative de fraude devienne inférieur ou égal au premier taux de fraude prédéterminé.

On considère en effet qu'on ne peut pas avoir simultanément plus de F3% de tentatives de fraude sur tous les compteurs du troisième ensemble 3.

F3 est le premier taux de fraude prédéterminé et est ici égal à 10%.

Ainsi, si le troisième module d'application 10 détecte plus de 10% de compteurs victimes d'une tentative de fraude, cela signifie que le troisième seuil de détection Seuil_Nc est mal réglé et est trop bas. On ajuste dynamiquement le troisième seuil de détection Seuil_Nc pour diminuer le taux détecté de compteurs subissant une fraude de manière à ce qu'il devienne inférieur ou égal à 10%.

On s'intéresse maintenant aux compteurs du quatrième ensemble de compteurs 4, qui mettent en œuvre un quatrième mode de surveillance et qui communiquent, via les *gateways* 5 et le module LNS 7, avec le quatrième module d'application 11 du SI 6.

Les compteurs du quatrième ensemble 4 sont des compteurs de gaz et sont chacun agencés pour mesurer une quantité de gaz distribuée à une installation par un réseau de distribution.

Chaque compteur est équipé d'un magnétomètre 3D destiné à détecter une tentative de fraude magnétique.

Le compteur transmet régulièrement au SI 6 des trames contenant des données classiquement transmises par un tel compteur de gaz. Ces données incluent des données de mesure représentatives de la quantité de gaz distribuée à l'installation, par exemple l'index totalisateur métrologique, ainsi que diverses autres données.

Pour mettre en oeuvre le procédé de surveillance selon l'invention, le compteur va, en plus de ces trames habituelles, transmettre au SI 6 des trames de surveillance.

A nouveau, le compteur envoie ici 4 trames de surveillance par jour, soit une toutes les 6 heures. Ces nouvelles trames de surveillance représentent donc une durée totale de 2,5s toutes les 6 heures.

On décrit maintenant, pour chaque compteur du quatrième ensemble de compteurs 4, le contenu des trames de surveillance.

Le composant de traitement du compteur produit des mesures primaires d'une grandeur représentative de la survenue d'une anomalie associée au compteur. L'anomalie possiblement détectée est une tentative de fraude magnétique sur le compteur.

La grandeur représentative de la survenue de la tentative de fraude est la grandeur magnétique :

$$|Bx| + |By| + |Bz|,$$

Bx, By et Bz étant des valeurs en Tesla d'un champ magnétique mesuré par le magnétomètre 3D selon les trois axes Euclidiens respectifs X, Y et Z.

Le composant de traitement acquiert une mesure toutes les 1s de la grandeur magnétique, réalisée par le magnétomètre 3D.

Les valeurs Bx, By et Bz de la grandeur magnétique forment donc les mesures primaires.

Puis, le composant de traitement sélectionne, parmi les mesures primaires, des mesures pertinentes qui vérifient un critère de pertinence.

Le critère de pertinence est tel que les mesures pertinentes comprennent, sur une septième durée prédéterminée, un deuxième nombre prédéterminé des mesures primaires les plus élevées, c'est-à-dire les valeurs Bx, By et Bz des grandeurs magnétiques les plus élevées.

Le deuxième nombre prédéterminé Np2 est ici égal à 16 et la septième durée prédéterminée est ici égale à 6 heures. On sélectionne donc les 16 grandeurs magnétiques les plus élevées max(|Bx|+|By|+|Bz|) sur une durée de 6 heures.

Le composant de traitement transmet régulièrement au SI 6 les mesures pertinentes précitées, soit les valeurs Bx, By et Bz des 16 grandeurs magnétiques les plus élevées, en l'occurrence toutes les 6 heures.

Le quatrième module d'application 11 du SI 6 reçoit les trames de surveillance ou, plus précisément, des paquets de surveillance 14. Chaque paquet de surveillance 14 comprend une adresse 15 du compteur qui l'envoie, ainsi qu'une trame de surveillance LoRa 16 qui comprend un *header* qui désigne le quatrième mode de surveillance dans lequel fonctionne le compteur (qui appartient au quatrième ensemble de compteurs 4), ce qui permet de diriger le paquet de surveillance 14 vers le quatrième module d'application 11.

Pour chaque compteur, le quatrième module d'application 11 réalise une comparaison des mesures pertinentes avec un quatrième seuil de détection commun à tous les compteurs du quatrième ensemble de compteurs 4, pour tenter de détecter une tentative de fraude sur le compteur.

Pour chaque compteur du quatrième ensemble 4, le SI 6 reçoit donc toutes les 6 heures les valeurs respectives Bx, By et Bz pour chacune des 16 grandeurs magnétiques les plus élevées, correspondant ainsi à 48 octets transmis audit SI 6.

Le quatrième module d'application 11 calcule alors, pour chaque grandeur magnétique |Bx|+|By|+|Bz| reçue, le module B du champ magnétique via la formule :

$$B = \sqrt{B_x^2 + B_y^2 + + B_z^2}.$$

Le quatrième module d'application 11 détecte une tentative de fraude sur le compteur lorsque, sur une huitième durée prédéterminée, on a au moins une valeur du module B telle que :

$$B > Seuil\_B,$$

où Seuil_B est le quatrième seuil de détection.

La huitième durée prédéterminée est égale à 6 heures et correspond donc aux 16 grandeurs magnétiques les plus élevées reçues par le SI 6.

Ainsi, le quatrième module d'application 4 détecte une tentative de fraude magnétique sur le compteur si au moins une des 16 valeurs de B est telle que B > Seuil_B.

Le quatrième module d'application 4 va aussi ajuster dynamiquement le quatrième seuil de détection Seuil_B en fonction d'un taux détecté d'anomalies, c'est-à-dire d'un taux détecté de compteurs subissant une tentative de fraude.

Le SI 6 reçoit en effet périodiquement les trames de surveillance émises par tous les compteurs du quatrième ensemble de compteurs 4, auxquels il est connecté via le réseau LoRa.

Lorsque le taux détecté de compteurs subissant une tentative de fraude est supérieur à un deuxième taux de fraude prédéterminé, le quatrième module d'application 11 augmente le quatrième seuil de détection Seuil_B pour que le taux détecté de compteur subissant une tentative de fraude devienne inférieur ou égal au deuxième taux de fraude prédéterminé.

On considère en effet qu'on ne peut pas avoir simultanément plus de F4% de tentatives de fraude sur tous les compteurs du quatrième ensemble 4.

F4 est le deuxième taux de fraude prédéterminé et est ici égal à 10%.

Ainsi, si le quatrième module d'application 11 détecte plus de 10% de compteurs victimes d'une tentative de fraude, cela signifie que le quatrième seuil de détection Seuil_B est mal réglé et est trop bas. Le quatrième module d'application 11 ajuste dynamiquement le quatrième seuil de détection Seuil_B pour diminuer le taux détecté de compteurs subissant une fraude de manière à ce qu'il devienne inférieur ou égal à 10%.

Bien entendu, l'invention n'est pas limitée au mode de réalisation décrit mais englobe toute variante entrant dans le champ de l'invention telle que définie par les revendications.

Il serait bien sûr possible de mettre en œuvre plusieurs modes de surveillance sur des compteurs d'un même ensemble, par exemple un mode de surveillance d'un défaut de l'installation et un mode de surveillance d'une tentative de fraude.

L'invention n'est pas applicable uniquement aux compteurs d'eau ou de gaz, mais peut être mise en oeuvre sur tout type de compteur.

On pourrait ainsi par exemple mettre en oeuvre l'invention sur des compteurs de chaleur qui, dans un appartement d'un immeuble, évaluent l'énergie thermique consommée par l'appartement en mesurant la différence de température entre l'entrée et la sortie de la canalisation d'eau chaude (dédiée au chauffage par radiateurs) de l'appartement.

L'invention est aussi applicable aux pipelines transportant du pétrole ou du gaz.

L'invention peut aussi être mise en oeuvre sur des compteurs électriques, qui pourraient alors envoyer un volume conséquent de données.

On note que le dispositif de traitement distant peut bien entendu utiliser le *Cloud* (que l'on peut traduire en français par « nuage ») pour sous-traiter au moins une partie des algorithmes.

Le dispositif de traitement distant n'est pas nécessairement un SI mais pourrait être un équipement ou un système différent, par exemple un concentrateur de données relié à un ensemble de compteurs.

Bien qu'ici dans le cas des compteurs à gaz, les mesures pertinentes sont les valeurs Bx, By et Bz, les mesures pertinentes pourront directement être les grandeurs magnétiques.

**Revendications**

1. Procédé de surveillance d'un ensemble de compteurs (1, 2, 3, 4), chaque compteur étant agencé pour mesurer un flux fourni à une installation par un réseau de distribution, tous les compteurs étant connectés à un même dispositif de traitement distant (6), le procédé de surveillance comprenant les premières étapes, mises en oeuvre dans chaque compteur, de :

   - acquérir des mesures primaires d'une grandeur représentative de la survenue d'une anomalie associée audit compteur ;
   - sélectionner, parmi les mesures primaires, des mesures pertinentes qui vérifient un critère de pertinence ;
   - transmettre régulièrement au dispositif de traitement distant les mesures pertinentes ;

   et les deuxièmes étapes, mises en oeuvre dans le dispositif de traitement distant (6), de :

   - pour chaque compteur, réaliser une comparaison des mesures pertinentes avec un seuil de détection commun à tous les compteurs de l'ensemble de compteurs, pour tenter de détecter une anomalie associée audit compteur ;
   - ajuster dynamiquement le seuil de détection en fonction d'un taux détecté d'anomalies.

2. Procédé de surveillance selon la revendication 1, dans lequel une anomalie associée à un compteur est un défaut dans l'installation associée audit compteur ou une tentative de fraude sur ledit compteur.

3. Procédé de surveillance selon la revendication 2, dans lequel les compteurs sont des compteurs d'un fluide, et dans lequel le défaut dans l'installation possiblement détecté est une fuite du fluide dans l'installation.

4. Procédé de surveillance selon la revendication 3, dans lequel les compteurs comprennent chacun un dispositif de mesure ultrasonique d'une vitesse du fluide, dans lequel la grandeur représentative de la survenue d'une fuite est une vitesse moyennée Vmoy du fluide sur une première durée prédéterminée, et dans lequel le critère de pertinence est la condition :

$$|Vmoy| \leq Seuil\_V1,$$

où |Vmoy| est une valeur absolue de la vitesse moyennée Vmoy et où Seuil_V1 est un seuil de vitesse prédéterminé.

5. Procédé de surveillance selon la revendication 4, dans lequel, pour chaque compteur, le dispositif de traitement distant (6) détecte une fuite dans l'installation associée audit compteur lorsque, sur une deuxième durée prédéterminée, on a : N1 ≥ K1, où K1 est un seuil de fuite prédéterminé, et où N1 est le nombre de vitesses moyennées telles que :

$$Vmoy > Seuil\_V2,$$

où Seuil_V2 est le seuil de détection.

6. Procédé de surveillance selon la revendication 5, dans lequel, lorsqu'un taux détecté d'installations subissant une fuite est supérieur à un premier taux de fuite prédéterminé, le dispositif de traitement distant (6) augmente le seuil de détection pour que le taux détecté d'installations subissant une fuite devienne inférieur ou égal au premier taux de fuite prédéterminé.

7. Procédé de surveillance selon la revendication 3, dans lequel la grandeur représentative de la survenue d'une fuite est une différence d'index ΔC entre une valeur maximale et une valeur minimale d'un index métrologique du compteur sur une troisième durée prédéterminée, et dans lequel le critère prédéterminé est la condition :
ΔC ≤ Seuil_C1, où Seuil_C1 est un seuil d'index prédéterminé.

8. Procédé de surveillance selon la revendication 7, dans lequel, pour chaque compteur, le dispositif de traitement distant (6) détecte une fuite dans l'installation associée audit compteur lorsque, sur une quatrième durée prédéterminée, on a :

$$(\Delta Cmax - \Delta Cmin) \geq Seuil\_C2,$$

où $\Delta Cmax$ est la valeur maximale de la différence d'index $\Delta C$ et où $\Delta Cmin$ est la valeur minimale de la différence d'index $\Delta C$, et où $Seuil\_C2$ est le seuil de détection.

9. Procédé de surveillance selon la revendication 8, dans lequel, lorsqu'un taux détecté d'installations subissant une fuite est supérieur à un deuxième taux de fuite prédéterminé, le dispositif de traitement distant (6) augmente le seuil de détection pour que le taux détecté d'installations subissant une fuite devienne inférieur ou égal au deuxième taux de fuite prédéterminé.

10. Procédé de surveillance selon la revendication 2, dans lequel les compteurs sont des compteurs d'un fluide qui comprennent chacun un dispositif de mesure ultrasonique d'une vitesse du fluide, et dans lequel la tentative de fraude possiblement détectée est une tentative de fraude ultrasonique.

11. Procédé de surveillance selon la revendication 10, dans lequel la grandeur représentative de la survenue de la tentative de fraude est un niveau de signal ultrasonique parasite mesuré lorsque le dispositif de mesure ultrasonique n'émet pas de signal ultrasonique de mesure, et dans lequel le critère de pertinence est tel que les mesures pertinentes comprennent, sur une cinquième durée prédéterminée, un premier nombre prédéterminé des niveaux de signal ultrasonique parasite les plus élevés en valeur absolue.

12. Procédé de surveillance selon la revendication 11, dans lequel, pour chaque compteur, le dispositif de traitement distant (6) détecte une tentative de fraude lorsque, sur une sixième durée prédéterminée, on a : $N2 \geq K2$, où $K2$ est un seuil de fraude prédéterminé, et où $N2$ est le nombre de niveaux de signal ultrasonique parasite tels que :

$$|Nc| > Seuil\_Nc,$$

où $Seuil\_Nc$ est le seuil de détection.

13. Procédé de surveillance selon la revendication 12, dans lequel, lorsqu'un taux détecté de compteurs subissant une tentative de fraude est supérieur à un premier taux de fraude prédéterminé, le dispositif de traitement distant (6) augmente le seuil de détection pour que le taux détecté de compteurs subissant une tentative de fraude devienne inférieur ou égal au premier taux de fraude prédéterminé.

14. Procédé de surveillance selon la revendication 2, dans lequel les compteurs comprennent chacun un magnétomètre destiné à détecter une tentative de fraude magnétique.

15. Procédé de surveillance selon la revendication 14, dans lequel le magnétomètre est un magnétomètre 3D, dans lequel la grandeur représentative de la survenue de la tentative de fraude est une grandeur magnétique égale à :

$$(|Bx| + |By| + |Bz|),$$

$Bx$, $By$ et $Bz$ étant des valeurs en Tesla d'un champ magnétique mesuré selon trois axes X, Y et Z, et dans lequel le critère de pertinence est tel que les mesures pertinentes comprennent, sur une septième durée prédéterminée, un deuxième nombre prédéterminé des valeurs $Bx$, $By$ et $Bz$ des grandeurs magnétiques les plus élevées.

16. Procédé de surveillance selon la revendication 15, dans lequel, pour chaque compteur, le dispositif de traitement distant (6) détecte une tentative de fraude lorsque, sur une huitième durée prédéterminée, on a au moins une valeur du module B telle que :

$$B > Seuil\_B,$$

où $Seuil\_B$ est le seuil de détection et où :

$$B = \sqrt{B_x^2 + B_y^2 + + B_z^2}.$$

17. Procédé de surveillance selon la revendication 16, dans lequel, lorsqu'un taux détecté de compteurs subissant une tentative de fraude est supérieur à un deuxième taux de fraude prédéterminé, le dispositif de traitement distant (6) augmente le seuil de détection pour que le taux détecté de compteurs subissant une tentative de fraude devienne inférieur ou égal au deuxième taux de fraude prédéterminé.

18. Système de mesure comprenant un ensemble de compteurs (1, 2, 3, 4) et un dispositif de traitement distant (6), chaque compteur étant agencé pour mesurer un flux fourni à une installation par un réseau de distribution, tous les compteurs étant connectés au dispositif de traitement distant, le procédé de surveillance selon l'une des revendications précédentes étant mis en oeuvre dans ledit système de mesure.

19. Dispositif de traitement distant (6), agencé pour être connecté à un ensemble de compteurs (1, 2, 3, 4), chaque compteur étant agencé pour mesurer un flux fourni à une installation par un réseau de distribution, le dispositif de traitement distant (6) comprenant un module d'application (8, 9, 10, 11) dans lequel les deuxièmes étapes du procédé de surveillance selon l'une des revendications 1 à 17 sont mises en oeuvre.

**Patentansprüche**

1. Verfahren zur Überwachung einer Gesamtheit von Zählern (1, 2, 3, 4), wobei jeder Zähler ausgebildet ist, einen Fluss zu messen, der von einem Verteilungsnetz an eine Anlage geliefert wird, wobei alle Zähler mit einer selben entfernten Verarbeitungsvorrichtung (6) verbunden sind, wobei das Überwachungsverfahren die ersten Schritte umfasst, die in jedem Zähler durchgeführt werden:

   - Erfassen von primären Messungen einer Größe, die repräsentativ für das Auftreten einer Anomalie ist, die mit dem genannten Zähler verbunden ist;
   - Auswählen von relevanten Messungen aus den primären Messungen, wobei die relevanten Messungen ein Relevanzkriterium erfüllen;
   - regelmäßiges Übertagen der relevanten Messungen an die entfernte Verarbeitungsvorrichtung;

und die zweiten Schritte, die in der entfernten Verarbeitungsvorrichtung (6) durchgeführt werden:

   - Durchführen, für jeden Zähler, eines Vergleichs der relevanten Messungen mit einem Erfassungsschwellenwert, der allen Zählern der Gesamtheit von Zählern gemeinsam ist, um zu versuchen, eine mit dem genannten Zähler verbundene Anomalie zu erfassen;
   - dynamisches Anpassen des Erfassungsschwellenwerts in Abhängigkeit von einer festgestellten Rate von Anomalien.

2. Überwachungsverfahren nach Anspruch 1, bei dem eine mit einem Zähler verbundene Anomalie ein Fehler in der mit dem genannten Zähler verbundenen Anlage oder ein Betrugsversuch an dem genannten Zähler ist.

3. Überwachungsverfahren nach Anspruch 2, bei dem die Zähler Fluidzähler sind und bei dem der möglicherweise in der Anlage erfasste Fehler ein Fluidleck in der Anlage ist.

4. Überwachungsverfahren nach Anspruch 3, bei dem die Zähler jeweils eine Ultraschallmessvorrichtung zum Messen einer Geschwindigkeit des Fluids umfassen, bei dem die Größe, die repräsentativ für das Auftreten eines Lecks eine gemittelte Geschwindigkeit Vmoy des Fluids über eine erste vorbestimmte Dauer ist und bei dem das Relevanzkriterium die Bedingung ist:

$$|Vmoy| \leq Seuil\_V1,$$

wobei |Vmoy| ein Absolutwert der gemittelten Geschwindigkeit |Vmoy| und wobei Seuil_V1 ein vorbestimmter Geschwindigkeitsschwellenwert ist.

5. Überwachungsverfahren nach Anspruch 4, bei dem, für jeden Zähler, die entfernte Verarbeitungsvorrichtung (6) ein Leck in der mit dem genannten Zähler verbundenen Anlage erfasst, wenn man über eine zweite vorbestimmte Dauer hat:
$N1 \geq K1$, wobei K1 ein vorbestimmter Leckschwellenwert ist und wobei N1 die Anzahl von gemittelten Geschwindigkeiten ist, derart dass:

$$Vmoy > Seuil\_V2,$$

wobei Seuil_V2 der Erfassungsschwellenwert ist.

6. Überwachungsverfahren nach Anspruch 5, bei dem, wenn eine erfasste Rate von Anlagen, die ein Leck erfahren, größer als eine erste vorbestimmte Leckrate ist, die entfernte Verarbeitungsvorrichtung (6) den Erfassungsschwellenwert erhöht, damit die erfasste Rate von Anlagen, die ein Leck erfahren, kleiner oder gleich der ersten vorbestimmten Leckrate wird.

7. Überwachungsverfahren nach Anspruch 3, bei dem die Größe, die repräsentativ für das Auftreten eines Lecks ist, eine Indexdifferenz $\Delta C$ zwischen einem Maximalwert und einem Minimalwert eines messtechnischen Index des Zählers über eine dritte vorbestimmte Dauer ist, und bei dem das vorbestimmte Kriterium die Bedingung ist:
$\Delta C \leq Seuil\_C1$, wobei Seuil_C1 ein vorbestimmter Indexschwellenwert ist.

8. Überwachungsverfahren nach Anspruch 7, bei dem die entfernte Verarbeitungsvorrichtung (6) für jeden Zähler ein Leck in der mit dem genannten Zähler verbundenen Anlage erfasst, wenn man über eine vierte vorbestimmte Dauer hat:

$$(\Delta Cmax - \Delta cmin) \geq Seuil\_C2,$$

wobei $\Delta$Cmax der Maximalwert der Indexdifferenz $\Delta$C ist und wobei $\Delta$Cmin der Minimalwert der Indexdifferenz $\Delta$C ist, und wobei Seuil _C2 der Erfassungsschwellenwert ist.

9. Überwachungsverfahren nach Anspruch 8, bei dem, wenn eine erfasste Rate von Anlagen, die ein Leck erfahren, größer als eine zweite vorbestimmte Leckrate ist, die entfernte Verarbeitungsvorrichtung (6) den Erfassungsschwellenwert erhöht, damit die erfasste Rate von Anlagen, die ein Leck erfahren, kleiner oder gleich der zweiten vorbestimmten Leckrate wird.

10. Überwachungsverfahren nach Anspruch 2, bei dem die Zähler Fluidzähler sind, die jeweils eine Ultraschallmessvorrichtung zum Messen einer Fluidgeschwindigkeit umfassen, und bei dem der möglicherweise erfasste Betrugsversuch ein Ultraschallbetrugsversuch ist.

11. Überwachungsverfahren nach Anspruch 10, bei dem die Größe, die repräsentativ für das Auftreten des Betrugsversuchs ist, ein Störultraschallsignalniveau ist, das gemessen wird, wenn die Ultraschallmessvorrichtung kein Messultraschallsignal aussendet, und bei dem das Relevanzkriterium derart ist, dass die relevanten Messungen über eine fünfte vorbestimmte Dauer eine erste vorbestimmte Anzahl von Störultraschallsignalniveaus umfassen, die den höchsten Absolutwert haben.

12. Überwachungsverfahren nach Anspruch 11, bei dem die entfernte Verarbeitungsvorrichtung (6) für jeden Zähler einen Betrugsversuch erfasst, wenn man über eine sechste vorbestimmte Dauer hat: $N2 \geq K2$, wobei K2 ein vorbestimmter Betrugsschwellenwert ist und wobei N2 die Anzahl an Störultraschallsignalniveaus ist, derart dass: $| Nc | >$ Seuil_Nc, wobei Seuil_Nc der Erfassungsschwellenwert ist.

13. Überwachungsverfahren nach Anspruch 12, bei dem, wenn eine erfasste Rate von Zählern, die einen Betrugsversuch erfahren, größer als eine erste vorbestimmte Betrugsrate ist, die entfernte Verarbeitungsvorrichtung (6) den Erfassungsschwellenwert erhöht, damit die erfasste Rate von Zählern, die einen Betrugsversuch erfahren, kleiner oder gleich der ersten vorbestimmten Betrugsrate wird.

14. Überwachungsverfahren nach Anspruch 2, bei dem die Zähler jeweils ein Magnetometer umfassen, das dazu bestimmt ist, einen magnetischen Betrugsversuch zu erfassen.

15. Überwachungsverfahren nach Anspruch 14, bei dem das Magnetometer ein 3D-Magnetometer ist, bei dem die Größe, die repräsentativ für das Auftreten des Betrugsversuchs ist, eine magnetische Größe ist, die gleich ist:

$$( | Bx | + | By | + | Bz | ),$$

wobei Bx, By und Bz Tesla-Werte eines Magnetfelds sind, das gemäß drei Achsen X, Y und Z gemessen wird, und bei dem das Relevanzkriterium derart ist, dass die relevanten Messungen über eine siebte vorbestimmte Dauer eine zweite vorbestimmte Anzahl von Werten Bx, By, Bz der höchsten magnetischen Größen umfassen.

16. Überwachungsverfahren nach Anspruch 15, bei dem die entfernte Verarbeitungsvorrichtung (6) für jeden Zähler einen Betrugsversuch erfasst, wenn man über eine achte vorbestimmte Dauer mindestens einen Wert des Moduls B hat, derart, dass

$$B > Seuil\_B,$$

wobei Seuil_B der Erfassungsschwellenwert ist und wobei:

$$B = \sqrt{B_x^2 + B_y^2 + + B_z^2}.$$

17. Überwachungsverfahren nach Anspruch 16, bei dem, wenn eine erfasste Rate von Zählern, die einen Betrugsversuch erfahren, größer als eine zweite vorbestimmte Betrugsrate ist, die entfernte Verarbeitungsvorrichtung (6) den Erfassungsschwellenwert erhöht, damit die erfasste Rate von Zählern, die einen Betrugsversuch erfahren, kleiner oder gleich der zweiten vorbestimmten Betrugsrate wird.

18. Messsystem, umfassend eine Gesamtheit von Zählern (1, 2, 3, 4) und eine entfernte Verarbeitungsvorrichtung (6), wobei jeder Zähler ausgebildet ist, einen Fluss zu messen, der von einem Verteilungsnetz an eine Anlage geliefert wird, wobei alle Zähler mit der entfernten Verarbeitungsvorrichtung verbunden sind, wobei das Überwachungsverfahren nach einem der vorhergehenden Ansprüche in dem genannten Messsystem durchgeführt wird.

19. Entfernte Verarbeitungsvorrichtung (6), die ausgebildet ist, mit einer Gesamtheit von Zählern (1, 2, 3, 4) verbunden zu werden, wobei jeder Zähler ausgebildet ist, einen Fluss zu messen, der von einem Verteilungsnetz an eine Anlage geliefert wird, wobei die entfernte Verarbeitungsvorrichtung (6) ein Anwendungsmodul (8, 9, 10, 11) umfasst, in dem die zweiten Schritte des Überwachungsverfahrens nach einem der Ansprüche 1 bis 17 durchgeführt werden.

## Claims

1. A monitoring method for monitoring a set of meters (1, 2, 3, 4), each meter being arranged to measure a stream supplied to an installation by a distribution network, all of the meters being connected to a common remote processor device (6), the monitoring method comprising both first steps performed in each meter, for:

   · acquiring primary measurements of a magnitude representative of the occurrence of an anomaly associated with said meter;
   · selecting pertinent measurements from the primary measurements, the pertinent measurements satisfying a pertinence criterion;
   · regularly transmitting the pertinent measurements to the remote processor device;

   and second steps performed in the remote processor device (6), for:

   · comparing, for each meter, the pertinent measurements with a detection threshold common to all of the meters of the set of meters in order to attempt detecting an anomaly associated with said meter;
   · adjusting the detection threshold dynamically as a function of the percentage of meters detected as being associated with an anomaly.

2. A monitoring method according to claim 1, wherein an anomaly associated with a meter is a fault in the installation associated with said meter or an attempt at fraud on said meter.

3. A monitoring method according to claim 2, wherein the meters are fluid flow meters, and wherein the fault that might potentially be detected in the installation is a leak of fluid in the installation.

4. A monitoring method according to claim 3, wherein each meter comprises an ultrasonic measurement device for measuring a fluid speed, wherein the magnitude representative of the occurrence of a leak is the speed Vmean of the fluid averaged over a first predetermined duration, and wherein the pertinence criterion is the following condition:

   $$|\text{Vmean}| \leq \text{Thresh\_V1},$$

   where |Vmean| is the absolute value of the averaged speed Vmean and where Thresh_V1 is a predetermined speed threshold.

5. A monitoring method according to claim 4, wherein, for each meter, the remote processor device (6) detects a leak in the installation associated with said meter when, over a second predetermined duration, the following applies:

   $N1 \geq K1$, where K1 is a predetermined leak threshold, and where N1 is the number of averaged speeds for which:

   $$\text{Vmean} > \text{Thresh\_V2},$$

   where Thresh_V2 is the detection threshold.

6. A monitoring method according to claim 5, wherein, when the percentage of installations detected as being subjected to a leak is greater than a first predetermined leak percentage, the remote processor device (6) increases the detection threshold so that the percentage of installations detected as being subjected to a leak becomes less than or equal to the first predetermined leak percentage.

7. A monitoring method according to claim 3, wherein the magnitude representative of the occurrence of a leak is a count difference $\Delta C$ between a maximum value and a minimum value for a measurement count of the meter over a third predetermined duration, and wherein the predetermined criterion is the following condition:

   $$\Delta C \leq \text{Thresh\_C1},$$

   where Thresh_C1 is a predetermined count threshold.

8. A monitoring method according to claim 7, wherein, for each meter, the remote processor device (6) detects a leak in the installation associated with said meter when, over a fourth predetermined duration, the following applies:

   $$(\Delta\text{Cmax} - \Delta\text{Cmin}) \geq \text{Thresh\_C2},$$

   where $\Delta$Cmax is the maximum value of the count difference $\Delta C$, where $\Delta$Cmin is the minimum value of the count difference $\Delta C$, and where Thresh_C2 is the detection threshold.

9. A monitoring method according to claim 8, wherein, when the percentage of installations detected as being subjected to a leak is greater than a second predetermined leak percentage, the remote processor device (6) increases the detection threshold so that the percentage of installations detected as being subjected to a leak becomes less than or equal to the second predetermined leak percentage.

10. A monitoring method according to claim 2, wherein the meters are fluid flow meters, each comprising an ultrasonic measurement device for measuring fluid speed, and wherein an attempt at fraud that might potentially be detected is an attempt at ultrasonic fraud.

11. A monitoring method according to claim 10, wherein the magnitude representative of the occurrence of an attempt at fraud is an interfering ultrasonic signal level measured while the ultrasonic measurement device is not emitting a measurement ultrasonic signal, and wherein the pertinence criterion is such that the pertinent measurements comprise, over a fifth predetermined duration, a first predetermined number of interfering ultrasonic signal levels having the greatest absolute value.

12. A monitoring method according to claim 11, wherein, for each meter, the remote processor device (6) detects an attempt at fraud when, over a sixth predetermined duration, the following applies: $N2 \geq K2$, where K2 is a predetermined fraud threshold, and where N2 is the number of interfering ultrasonic signal levels Nc such that:
|Nc| > Thresh_Nc, where Thresh_Nc is the detection threshold.

13. A monitoring method according to claim 12, wherein, when the percentage of meters detected as being subjected to an attempt at fraud is greater than a first predetermined fraud percentage, the remote processor device (6) increases the detection threshold so that the percentage of meters detected as being subjected to an attempt at fraud becomes less than or equal to the first predetermined fraud percentage.

14. A monitoring method according to claim 2, wherein each meter includes a magnetometer for detecting an attempt at magnetic fraud.

15. A monitoring method according to claim 14, wherein the magnetometer is a 3D magnetometer, wherein the magnitude representative of the occurrence of an attempt at fraud is a magnetic magnitude equal to:

$$( |Bx| + |By| + |Bz| ),$$

Bx, By, and Bz being the values in teslas of a magnetic field measured along three axes X, Y, and Z, and wherein the pertinence criterion is such that the pertinent measurements comprise, over a seventh predetermined duration, a second predetermined number of the values Bx, By, and Bz of the greatest magnetic magnitudes.

16. A monitoring method according to claim 15, wherein, for each meter, the remote processor device (6) detects an attempt at fraud when, over an eighth predetermined duration, there is at least one value of the modulus B such that:

$$B > \text{Thresh\_B},$$

where Thresh_B is the detection threshold, and where:

$$B = \sqrt{B_x^2 + B_y^2 + B_z^2}.$$

17. A monitoring method according to claim 16, wherein, when the percentage of meters detected as being subjected to an attempt at fraud is greater than a second predetermined fraud percentage, the remote processor device (6) increases the detection threshold so that the percentage of meters detected as being subjected to an attempt at fraud becomes less than or equal to the second predetermined fraud percentage.

18. A measurement system comprising a set of meters (1, 2, 3, 4) and a remote processor device (6), each meter being arranged to measure a stream supplied to an installation by a distribution network, all of the meters being connected to the remote processor device, and the monitoring method according to any preceding claim being performed in said measurement system.

19. Remote processor device (6), arranged to be connected to a set of meters (1, 2, 3, 4), each meter being arranged to measure a stream supplied to an installation by a distribution network, the remote processor device including an application modulus (8, 9, 10, 11) in which the second steps of the monitoring method according to any one of claims 1 to 17 are performed.

Fig. 1

## RÉFÉRENCES CITÉES DANS LA DESCRIPTION

**Documents brevets cités dans la description**

- EP 2472467 A1